**Europäisches Patentamt**

**European Patent Office**

**Office européen des brevets**

(11) Veröffentlichungsnummer: **0 185 280**
**A2**

# EUROPÄISCHE PATENTANMELDUNG

(21) Anmeldenummer: 85115597.8

(22) Anmeldetag: 07.12.85

(51) Int. Cl.⁴: **G 03 F 7/26**
**G 03 F 7/10**

(30) Priorität: 18.12.84 DE 3446074

(43) Veröffentlichungstag der Anmeldung:
25.06.86 Patentblatt 86/26

(84) Benannte Vertragsstaaten:
BE DE FR GB NL

(71) Anmelder: Röhm GmbH
Kirschenallee Postfach 4242
D-6100 Darmstadt 1(DE)

(71) Anmelder: Max-Planck-Gesellschaft zur Förderung der
Wissenschaften e.V.
Bunsenstrasse 10
D-3400 Göttingen(DE)

(72) Erfinder: Asmussen, Frithjof, Dr.
Am Wieselbau 14
D-1000 Berlin 37(DE)

(72) Erfinder: Gänzler, Wolfgang, Dr.
Wixhäuser Strase 11
D-6100 Darmstadt(DE)

(72) Erfinder: Wunderlich, Winfried, Dr.
Spessartring 11
D-6101 Rossdorf 1(DE)

(54) Verfahren zur Herstellung von Röntgen-Resists.

(57) Verfahren zur Herstellung von Röntgenresists mit Ätzmustern unter Verwendung von an sich bekannten Trägern, die mit einem Film aus Copolymeren des Methacrylnitrils mit der Methacrylsäure beschichtet sind, wobei

a) zur Beschichtung des Trägers ein Copolymerisat des Methacrylnitrils und der Methacrylsäure mit einem Molekulargewicht unter 700 000 verwendet wird,

b) eine thermische Behandlung vor der Bestrahlung mit Röntgenstrahlung unterhalb 150 °C bis zur Bildung eines lösungsmittelfreien, unvernetzten Films durchgeführt wird,

c) nach der Bestrahlung mit Röntgenstrahlung bei Temperaturen im Bereich 140° – 170°C während 15 bis 30 Minuten getempert wird und

d) anschließend mit einem Lösungsmittelsystem L gebildet aus Wasser und/oder einem organischen Lösungsmittel, das Sauerstoff in Form einer Hydroxy- und/oder einer Ethergruppe und/oder einer Estergruppe enthält, entwickelt wird.

Verfahren zur Herstellung von Röntgen-Resists

## Gebiet der Erfindung

Die Erfindung betrifft ein Verfahren zur Herstellung von Röntgen-Resists auf der Basis von Copolymeren des Methacrylnitrils und der Methacrylsäure.

Derartige Resists dienen zur Herstellung von Halbleiterelementen. Durch Bestrahlung mit energiereicher Strahlung wie der Röntgenstrahlung gelingt es, auf relativ dünnen Polymerschichten mit hoher Präzision Zonen veränderter Löslichkeit im Submikronbereich herzustellen. Die Löslichkeit gegenüber spezifischen Lösungsmitteln kann durch Bestrahlung erhöht (positive Resists) oder vermindert werden (negative Resists). Die Verringerung der Löslichkeit des Polymermaterials dürfte überwiegend auf Vernetzungsreaktionen beruhen.

## Stand der Technik

Aus der europ. Offenlegungsschrift Nr. 64 864 sind Copolymere der Methacrylsäure und des Methacrylnitrils als positive Elektronenstrahl-Resists bekannt. Derartige Resists besitzen sowohl eine große Empfindlichkeit als eine hohe Plasma-Ätz-Resistenz. Zu Ihrer Herstellung beschichtet man ein Trägersubstrat, in der Regel ein in der Oberfläche oxidierter Silizium-Wafer mit einer Polymerisat-Lösung, so daß ein etwa 0,7 μ-Resist-Film entsteht. Der Resist-Film wird dann an der Luft (Feuchtigkeit 30 - 40 %) bei 160°C eine halbe Stunde getempert, anschließend der Elektronenstrahl-Behandlung ausgesetzt und schließlich mittels eines organischen Lösungsmittels (Methcellosolve) entwickelt.

Eine Weiterentwicklung stellt das Verfahren der europ. Offenlegungsschrift Nr. 81 633 dar. Danach wird die Beschichtung aus dem Methacrylsäure-Methacrylnitril-Copolymerisat in einem organischen Lösungsmittel (Diglym) mittels Schleuderbeschichtung hergestellt und einer zweistufigen Temperung unterworfen. Die erste Temperstufe soll bei 120 - 140 °C während 10 bis 30 Minuten erfolgen, während die zweite Temperstufe bei 140 - 150 °C ebenfalls während 10 bis 30 Minuten durchgeführt werden soll. Die Bestrahlung wird mit tiefem UV-Licht vorgenommen. Als Entwickler werden Methanol, Ethanol, wäßriges Ethanol und wäßriges Aceton getestet. Für hochaufgelöste Polymermuster wird wäßriges Ethanol empfohlen.

In einer Reihe weiterer Druckschriften werden Copolymerisate der Methacrylsäure mit Methacrylnitril meist zusammen mit Estern der Methacrylsäure wie MMA oder mit Isobutylen als Resists für energiereiche Strahlung empfohlen.
(Vgl. JP-OS 78-81 114, JP-OS 81-544 434, JP-OS 81-53 114, JP-OS 79-88 117, JP-OS 77-31 029, JP-OS 78-162 297).
Die besondere Eignung der Copolymerisate aus Methacrylsäure und Methacrylnitril wird in der US-PS 3 964 908 der Bildung von Dimethylglutarimideinheiten zugeschrieben. Hervorgehoben wird die erreichte hohe Auflösung, die hohe Glastemperatur und die günstige Wärmestabilität der auf dieser Polymerbasis hergestellten Resists (vgl. H. Hiraoka, L.W. Welsh, J. Bargon, J. Electrochem.Soc. May 1981, pg. 1065).

## Aufgabe

Die Polymerisate auf Basis Methacrylsäure/Methacrylnitril erfüllen in vieler Hinsicht die Forderungen der Technik an ein polymeres Substrat für Resistszwecke recht gut. Bei der Anwendung dieser Polymerisatklasse für die Röntgenlithographie ergeben sich teilweise abweichende Anforderungen der Technik. Zwar kann sich das Verfahren auf die technologischen Erfahrungen des genannten Standes der Technik stützen, aber es zeigte sich, daß die Temperungsschritte in Anlehnung an die EU-OS 81 633 nicht zu optimalen Resultaten führen. Weiter erwies sich die Entwicklung als verbesserungsbedürftig.

## Lösung

Es wurde gefunden, daß man positive Röntgenresists mit Ätzmustern von hoher Auflösung und sehr guter mechanischer und thermischer Resistenz erhalten kann, wenn man an sich bekannte Träger, die mit einem Film aus Copolymeren des Methacrylnitrils mit Methacrylsäure beschichtet sind, der Röntgenlithographie unterwirft, wobei

a)  ein Copolymerisat des Methacrylnitrils und der Methacrylsäure mit einem Molekulargewicht unter 700 000 zur Beschichtung des Trägers verwendet wird,

b)  eine thermische Behandlung vor der Bestrahlung mit Röntgenstrahlung unterhalb[*)]120 °C und zwar bis zur Bildung eines lösungsmittelfreien, unvernetzten Films durchgeführt wird,

*) 150, vorzugsweise im Bereich ab

c)  nach der Bestrahlung mit Röntgegenstrahlung bei Temperaturen im Bereich 140° bis 170° während 15 bis 30 Minuten getempert und

d)  anschließend mit einem Lösungsmittel L gebildet aus Wasser und/oder einem organischen Lösungsmittel, das Sauerstoff in Form einer Hydroxy- und/oder einer Ethergruppe und/oder einer Estergruppe enthält, entwickelt wird.

Das organische Lösungsmittel enthält vorzugsweise mindestens zwei Kohlenstoffatome, außer Kohlenstoff, Wasserstoff und Sauerstoff keine weiteren Atomarten. Umfaßt werden insbesondere die niederen Alkohole Ethanol und Propanol, ferner werden cyclische und lineare Ether und Ester umfaßt wie Ethoxyethylacetat, Dioxan und Glykolmonoether, insbesondere Oligoglykolmonoether wie die Di- und Triethylenglykolmonoether. Vorteilhaft ist die völlige Mischbarkeit des oder der organischen Lösungsmittel mit Wasser. Das Gewichts-Verhältnis Wasser zu organischem Lösungsmittel liegt gewöhnlich im Bereich 1 : 4 bis 1 : 7 Gewichtsteile.

Das strahlungsempfindliche Copolymerisat dient erfindungsgemäß zur Abbildung von Submikrostrukturen mittels Röntgenstrahlung, insbesondere zur Anwendung in weicher Röntgenstrahlung, wobei die Synchrotronstrahlung wegen ihrer hohen Intensität (Belichtungszeiten von einigen Sekunden) günstigen Wellenlänge ($\lambda_p \sim 1$ nm) und guten Kollimierung als optimale Strahlung hervorzuheben ist.

## Das Copolymerisat

Als polymere Basis auch für Röntgenresists hat sich besonders ein Copolymerisat aus Methacrylsäure/Methacrylnitril mit einem Molekulargewicht unter 700 000, vorzugsweise im Bereich 200 000 - 500 000 bewährt. Vorzugsweise besteht das Copolymerisat aus Methacrylsäure/Methacrylnitril im Verhältnis 75 : 25 bis 50 : 50 insbesondere 60 : 40 Gew.-%. Die Herstellung geschieht zweckmäßig in Form eines Substanzpolymerisats nach an sich bekanntem Verfahren. (Vgl. H. Rauch-Puntigam, Th. Völker in "Acryl- und Methacrylverbindungen", Springer-Verlag, Heidelberg, 1967). Als Initiatoren können die an sich bekannten, beispielsweise Perverbindungen wie Peroxide und Persäurederivate in den dafür verwendeten Quantitäten, beispielsweise 0,01 bis 0,1 Gew.-%, bezogen auf die Monomeren, angewendet werden. Als Regler eignen sich die einschlägig bekannten, insbesondere Schwefelregler, wie Mercaptane oder Thiosäuren, beispielsweise tert. Dodecylmercaptan. Die verwendeten Mengen an Regler liegen im üblichen Bereich, beispielsweise bei 0,01 bis 0,5 Gew.-%, bezogen auf die Monomeren.

## Herstellung des Copolymerisats:

Zur Herstellung des Copolymerisats kann z.B. wie folgt verfahren werden:

## Beispiel 1

Ein Gemisch aus 48 Gew.-Teilen Methacrylsäure, 32 Gew.-Teilen Methacrylnitril, 20 Gew.-Teilen Methoxyethanol werden unter Zusatz von 0,16 Gew.-Teilen eines Initiatorgemisches bestehend aus tert. Butylperpivalat, Dibenzoylperoxid und tert. Butylperbenzoat im Gewichts-Verhältnis 5 : 2,5 : 1,5 und 0,16 Gew.-Teilen Dodecylmercaptan als Regler oberhalb Raumtemperatur (ca. 42°C) innerhalb 72 Stunden zu einem harten, glasartigen Produkt polymerisiert. Anschließend wird noch ca. 3 Stunden bei 100°C getempert.

Träger und Beschichtung

Als Träger kommen die üblichen Materialien infrage z.B. für die Halbleiter-Anwendung Silizium-Wafer mit oxidierter Oberfläche (chrombedecktes) Glas, Metalle wie z.B. Aluminium u.ä. in den gängigen Abmessungen, beispielsweise 7,5 cm Durchmesser.

Die Beschichtung kann in an sich bekannter Weise vorgenommen werden, beispielsweise aus einer Lösung der Copolymeren heraus.
Als Lösungsmittel sind organische Lösungsmittel wie partiell veräterthe Polyole, insbesondere 2-Methoxyethanol geeignet. Die Beschichtung des Trägermaterials erfolgt in der Regel durch Aufschleudern (spin-coating).
Im allgemeinen soll die Schichtdicke des aufgetragenen Polymermaterials 2 µm nicht überschreiten, in der Regel liegt sie bei 0,1 - 2 µm, vorzugsweise bei 1,0 ± 0,2 µm.

## Vorheizung

Im Resist befindliche Lösungsmittelreste werden in einem Vorheizprozeß (150°C[*]; 30 Minuten) entfernt.

## Belichtung

Zur Strukturübertragung wird der beschichtete Wafer mit energiereicher Strahlung (Synchrotronstrahlung, deren maximale Strahlungsleistung bei einer Wellenlänge von ca. 1 nm liegt) hinter einer Maske, die die Strukturinformation enthält, bestrahlt. Die Bestrahlungsdosis beträgt 100 mJ/cm².

## Zwischenheizung

In einem Zwischenheizprozeß (170°C; 30 Minuten) wird der unbelichtete Bereich des Resists durch Imidierung stabilisiert und unlöslich gemacht.

## Entwicklung

Der belichtete Resist wird in einem Ethanol-Wasser Gemisch im Gewichtsverhältnis 7 : 1 bei einer Schichtdicke von 0,5 μm innerhalb von 30 Sekunden entwickelt. Der Dunkelabtrag ist sehr gering ($< 5$ %).

## Plasmaätzresistenz

Zur Übertragung von Submikrostrukturen auf den Halbleiter werden plasmaätzresistente Resists benötigt. Die hier be-

*) 120 bis gegen

schriebenen Copolymere aus Methacrylsäure und Methacrylnitril besitzen wegen ihrer Eigenschaft, bei höheren Temperaturen intra- und intermolekulare Imide zu bilden, eine sehr gute Plasmaätzresistenz. Die relative Ätzrate im $CF_4$, $O_2$ (4 %)-Plasma (0,5 torr; 150 W) beträgt $R_{rel} = 0,4$ bezogen auf Polymethylmethacrylat mit $R_{rel} = 1$ und AZ 1350 (Photolack) mit $R_{rel} = 0,5$.

Verfahren zur Herstellung von Röntgen-Resists

Patentansprüche

1. Verfahren zur Herstellung von Röntgenresists mit Ätzmustern unter Verwendung von an sich bekannten Trägern, die mit einem Film aus Copolymeren des Methacrylnitrils mit der Methacrylsäure beschichtet sind, wobei jeweils vor und nach der Bestrahlung thermisch behandelt wird und nachfolgender Entwicklung mit organischen Lösungsmitteln,

dadurch gekennzeichnet,

daß a) ein Copolymerisat des Methacrylnitrils und der Methacrylsäure mit einem Molekulargewicht unter 700 000 zur Beschichtung des Trägers verwendet wird,

b) eine thermische Behandlung vor der Bestrahlung mit Röntgenstrahlung unterhalb 150 °C bis zur Bildung eines lösungsmittelfreien, unvernetzten Films durchgeführt wird,

c) nach der Bestrahlung mit Röntgenstrahlung bei Temperaturen im Bereich 140° - 170°C während 15 bis 30 Minuten getempert wird und

d) anschließend mit einem Lösungsmittelsystem L gebildet aus Wasser und/oder einem organischen Lösungsmittel, das Sauerstoff in Form einer Hydroxy- und/oder einer Ethergruppe und/oder einer Estergruppe enthält, entwickelt wird.

2.  Verfahren gemäß Anspruch 1, dadurch gekennzeichnet, daß das Copolymerisat aus Methacrylsäure und Methacrylnitril im Verhältnis 75 : 25 Gew. bis 50 : 50 Gew.-% hergestellt wurde.

3.  Verfahren gemäß Anspruch 2, dadurch gekennzeichnet, daß das Copolymerisat aus Methacrylsäure und Methacrylnitril im Verhältnis 60 : 40 Gew.-% hergestellt wird.

4.  Verfahren gemäß den Ansprüchen 1 und 2, dadurch gekennzeichnet, daß das Copolymerisat ein Molekulargewicht im Bereich 200 000 - 500 000 besitzt.

5.  Verfahren gemäß Anspruch 1, dadurch gekennzeichnet, daß die thermische Behandlung nach Schritt b) bei 120 - 150 °C während 15 bis 30 Minuten durchgeführt wird.

6.  Verfahren gemäß Anspruch 1, dadurch gekennzeichnet, daß das Lösungsmittelsystem L aus Propanol-(2) und Wasser besteht.

7.  Verfahren gemäß Anspruch 1, dadurch gekennzeichnet, daß das Lösungsmittelsystem L aus Ethanol und Wasser besteht.

8.  Verfahren gemäß Anspruch 1, dadurch gekennzeichnet, daß das Lösungsmittel L aus 2-Methoxyäthanol und (2-Ethoxy- ethyl)-acetat besteht.